# EUROPEAN PATENT APPLICATION

(11) **EP 4 418 545 A1**
(43) Date of publication of application: **21.08.2024**
(21) Application number: 24157616.4
(22) Date of filing: 14.02.2024
(51) Int. Cl.: H04B 1/40, H04W 88/08, H05K 1/14

(54) **CIRCUIT STRUCTURE FOR MULTIPLE ANTENNA RADIO UNIT, BASE STATION, AND SATELLITE COMMUNICATION**

(30) Priority: 15.02.2023 TW 112105400
(71) Applicant: Ranictek Inc., Taipei 115603 (TW)
(72) Inventor: Wang, Yi-Fan, Nangang Dist., Taipei City (TW)
(74) Representative: Bandpay & Greuter

(57) **Abstract**

A circuit structure for multiple antenna radio units (RUs), base stations (BSs), and satellite communications is provided. Different from the current main technology using the circuit structure of a single printed circuit board (PCB), the circuit structure in this present disclosure consists of multiple PCBs (400), (800), and the required modules of the active antenna such as the antennas (411), (811) and RF components (412), (421), (812), (821); the digital circuit such as the fronthaul interface module (424), digital processing module of communications (422), beamforming module (423), (822), and baseband digital circuit module (823); and the power module (431), (831) in the RU, BS, and satellite communications are allocated into the multiple PCBs (400), (800). By elaborately allocating those modules into the multiple PCBs (400), (800), they can coordinate for achieving the required functionality, and the overall performance can be optimized. The circuit structure can also be used in Massive MIMO (Multiple-Input Multiple-Output) BSs such that the corresponding transmit power can be reduced as a green technology.

## Description

### Technical Field

The present invention relates to a circuit structure, in particular to a circuit structure for multiple antenna radio unit, base station, and satellite communications.

### Background Art

In wireless communication systems with multiple antennas, there are two types of antennas based on their antenna architecture: active antennas and passive antennas. Traditional fourth-generation (4G) mobile communication base stations (BSs) primarily use passive antennas, characterized by the separation of radio frequency (RF) components and antennas. In this architecture, the RF components are placed within a remote radio head (RRH), while the antennas are placed outside the RRH and connected to the RRH via cables. In contrast to the passive antenna, the active antenna integrates both the RF components and antennas to avoid or reduce cable losses. Due to the reduced loss, such an integration makes the active antenna architecture more suitable for wireless communication systems especially when the number of antennas is large. Hence, fifth-generation (5G) mobile communication base stations often use the active antenna architecture. For example, the RF components and antennas can be integrated into a radio unit (RU) of the base station.

In the active antenna architecture, the existing technologies commonly utilize a single-piece printed circuit board (PCB) as the mainstream. This approach integrates antennas, RF components, and baseband digital circuits into a single multilayer PCB. For example, in U.S. Patent No. US 9,391,370 B2, US 10,201,073 B2, and US 10,290,920 B2, they all consider similar multilayer PCB structure to integrate the antennas, RF components, and baseband digital circuits into a single PCB. However, in applications, such as RUs, base stations, and satellite communications with a large number of antennas in active antenna systems, using a single multilayer PCB has the following drawbacks. First, since the antennas, RF components, and digital circuits are integrated into a single PCB, the heat dissipation area is limited by the size of a single PCB. This limitation can result in low heat dissipation efficiency. Second, because the antennas, RF components, and digital circuits are closely integrated into a single PCB, there is a higher risk of electromagnetic interference (EMI) and electromagnetic compatibility (EMC) issues caused by the proximity of these components. Additionally, the use of a single PCB presents challenges in terms of maintenance and replacement, as any aging or damage to the PCB or internal components may render the entire system inoperative, leading to a shorter lifespan and reduced stability. The highly integrated nature of the system also makes it more challenging to address and repair specific damaged components. Furthermore, the three-dimensional configuration of all components in a single multilayer PCB increases the complexity of manufacturing, resulting in higher production cost and lower yield rate in mass production.

Based on the above, the existing technologies of the single PCB structure still suffers from shortcomings such as poor heat dissipation, high level of noise and interference, shorter lifespan, lower stability, difficulty in maintenance, higher cost, and lower yield rate in mass production. There is still a need for improvement.

### Summary of Invention

To address the drawbacks above, unlike the single-piece PCB structure, the disclosed embodiment utilizes a multiple PCB structure and integrates various modules required in RUs, base stations, and satellite communications, such as active antennas including antennas and RF components; digital circuits including fronthaul interface modules, communication digital signal processing modules, beamforming modules, and baseband digital circuit modules; as well as power modules. These modules are distributed among multiple PCBs. By appropriately assigning the modules on the multiple PCBs, they can collaboratively work together to achieve the desired functionalities and optimize the overall performance.

One embodiment of the disclosed invention provides a circuit structure for a RU, comprising multiple PCBs that can communicate data and/or signals between each other through any digital and/or analog interfaces. At least one PCB comprises an antenna module and at least another PCB comprises a fronthaul interface module. The PCB comprising the antenna module further comprises a RF front-end module. The PCB comprising the fronthaul interface module further comprises a RF module, a communication digital signal processing module, and a beamforming module. Besides the PCB comprising the antenna module and the PCB comprising the fronthaul interface module, there may be another PCB comprising a power module.

Another embodiment of the disclosed invention provides a circuit structure for a RU, comprising multiple PCBs that can communicate data and/or signals between each other through any digital and/or analog interfaces. At least one PCB comprises an antenna module and at least another PCB comprises a fronthaul interface module. The PCB comprising the antenna module further comprises a RF front-end module and a RF module. The PCB comprising the fronthaul interface module further comprises a communication digital signal processing module and a beamforming module. Besides the PCB comprising the antenna module and the PCB comprising the fronthaul interface module, there may be another PCB comprising a power module.

Another embodiment of the disclosed invention provides a circuit structure for a RU, comprising multiple PCBs that can communicate data and/or signals between each other through any digital and/or analog interfaces. At least one PCB comprises an antenna module and at least another PCB comprises a power module. The PCB comprising the antenna module further comprises a RF front-end module, a RF module, a communication digital signal processing module, and a beamforming module.

One embodiment of the disclosed invention provides a circuit structure for a base station and a satellite communication system, comprising multiple PCBs that can communicate data and/or signals between each other through any digital and/or analog interfaces. At least one PCB comprises an antenna module and at least another PCB comprises a baseband digital circuit module. The PCB comprising the antenna module further comprises a RF front-end module. The PCB comprising the baseband digital circuit module further comprises a RF module and a beamforming module. Besides the PCB comprising the antenna module and the PCB comprising the baseband digital circuit module, there may be another PCB comprising a power module.

Another embodiment of the disclosed invention provides a circuit structure for a base station and a satellite communication system, comprising multiple PCBs that can communicate data and/or signals between each other through any digital and/or analog interfaces. At least one PCB comprises an antenna module and at least another PCB comprises a baseband digital circuit module. The PCB comprising the antenna module further comprises a RF front-end module and a RF module. The PCB comprising the baseband digital circuit module further comprises a beamforming module. Besides the PCB comprising the antenna module and the PCB comprising the baseband digital circuit module, there may be another PCB comprising a power module.

Another embodiment of the disclosed invention provides a circuit structure for a base station and a satellite communication system, comprising multiple PCBs that can communicate data and/or signals between each other through any digital and/or analog interfaces. At least one PCB comprises an antenna module and at least another PCB comprises a power module. The PCB comprising the antenna module may further comprise a RF front-end module, a RF module, a beamforming module, and a baseband digital circuit module.

In accordance with the above, the disclosed embodiments of the circuit structures for RUs, base stations, and satellite communications use multiple PCBs and appropriately assigning various modules on these PCBs. It not only achieves the required functionalities but also optimizes the overall system performance and provides new benefits as follows. First, due to the use of multiple PCBs, the heat dissipation area is larger compared to the single PCB structure, resulting in improved heat dissipation efficiency. Second, as various circuit components can be placed on multiple PCBs, components that may cause EMI and EMC issues can be placed on different PCBs to increase the distance between those components, and thus reducing noise and interference. Third, the stability and lifespan of this structure using multiple PCBs are better than those of the single PCB structure. In applications the RU having multiple antennas, especially when the number of antennas is large, even if some PCBs or their internal components in certain antenna branches are damaged, the overall system may still operate properly under some performance decrease, extending its lifespan. When internal components of certain PCBs are damaged, it is only necessary to replace the damaged PCBs and its components, avoiding the need to replace the entire system, and hence facilitating maintenance. Fourth, for production, the complexity of the structure with multiple PCBs is relatively low, and hence reducing the overall circuit cost and improving the yield rate of mass production. Moreover, the disclosed circuit structure is particularly suitable for wireless communication systems with a large number of antennas, such as massive multiple-input multiple-output (Massive MIMO) base stations. In the Massive MIMO base station, as the number of antennas increases, given the same data rate, it effectively reduces the transmit power of both base stations and cell phones. The reduced transmit power is proportional to the number of antennas, meaning that as the number of antennas increases, the reduction in transmit power also increases. Thus, it reduces power consumption for both base stations and cell phones, achieving energy-saving and carbon reduction as a green technology.

In summary, the circuit structure disclosed herein not only achieves the required functions but also optimizes overall performance with additional benefits including improved heat dissipation, reduced noise and interference, longer lifespan, ease of maintenance and update, suitability for mass production with low circuit cost, and energy-saving and carbon reduction. Due to the heat dissipation benefit, it is more suitable for use in base stations and satellite communication systems, which have higher heat dissipation requirement. The property of low noise and interference enhances the stability and performance of base stations and satellite communication systems. The longer lifespan and ease of maintenance and update align well with the requirements of base stations and satellite communication systems. The telecom operators often demand a lifespan of the base station over 10 years. As the communication standard evolves, the modification or update to the internal circuits of the base station may be necessary. The benefit of mass production with low circuit cost and energy-saving may also propel the mass and dense deployment of 5G and even 6G base stations to popularize 5G and 6G technologies.

### Brief Description of Drawings

FIG. 1 depicts an illustration of a base station with RUs.
FIG. 2 depicts an illustration of a base station.
FIG. 3 depicts an illustration of a ground station in satellite communications.
FIG. 4 depicts one exemplary embodiment of a circuit structure for a RU.
FIG. 5 depicts another exemplary embodiment of a circuit structure for a RU.
FIG. 6 depicts another exemplary embodiment of a circuit structure for a RU.
FIG. 7 depicts another exemplary embodiment of a circuit structure for a RU.
FIG. 8 depicts one exemplary embodiment of a circuit structure for a base station and a satellite communication system.
FIG. 9 depicts another exemplary embodiment of a circuit structure for a base station and a satellite communication system.
FIG. 10 depicts another exemplary embodiment of a circuit structure for a base station and a satellite communication system.

### Detailed Description of the Invention

The following description is provided in conjunction with the accompanying drawings to illustrate specific embodiments, but these embodiments are not intended to limit the scope of the present disclosure. Any device resulting from the rearrangement of components to achieve equivalent functionality is within the scope of this disclosure. Furthermore, the drawings are for illustrative purposes and are not drawn to scale.

Regarding the use of "first," "second," etc., in this disclosure, it is not intended to denote a specific order or rank, nor is it used to limit the present invention. These terms are merely used for the purpose of distinguishing between different objects described herein.

Regarding the term " a plurality of printed circuit boards (PCBs)" used in this disclosure, it refers to multiple PCBs, indicating at least two or more PCBs. Each PCB can be single-sided (also referred to as single-layer), double-sided (also referred to as double-layer), or multilayer PCBs, and may involve any combinations of these three types.

Regarding the term "bidirectional transmission" used in this disclosure, it refers to the ability for signals or data transmission between A and B in both directions. Specifically, if A transmits signals or data bidirectionally to B, it means that A can send signals or data to B and/or B can send signals or data to A.

Regarding the term "radio unit (RU)" used in this disclosure, it refers to a system that comprises antennas, RF analog circuits, and digital circuits. For example, the open radio unit (O-RU) defined by the Open Radio Access Network (O-RAN) alliance falls under the scope of the RU as referred to in this disclosure. Additionally, other combinations such as systems combining O-RU with open distributed unit (O-DU) are also considered within the definition of the RU in this disclosure.

Regarding the term "distributed unit (DU)" used in this disclosure, it refers to a system connected to one or more RU(s) through one or more interface(s), and comprises digital circuits related to the physical layer (PHY) operations. For example, the O-DU defined by the O-RAN alliance falls under the scope of the DU as referred to in this disclosure. Other combinations, such as systems combining O-DU with open central unit (O-CU), are also considered within the definition of the DU in this disclosure.

Regarding the term "fronthaul interface" used in this disclosure, it refers to an interface connecting the RU and the DU. For example, the fronthaul interface defined by the O-RAN alliance, utilizing the evolved common public radio interface (eCPRI) protocol and comprising the control plane (C-Plane), user plane (U-Plane), synchronization plane (S-Plane), and management plane (M-Plane), falls within the scope of the fronthaul interface as referred to in this disclosure.

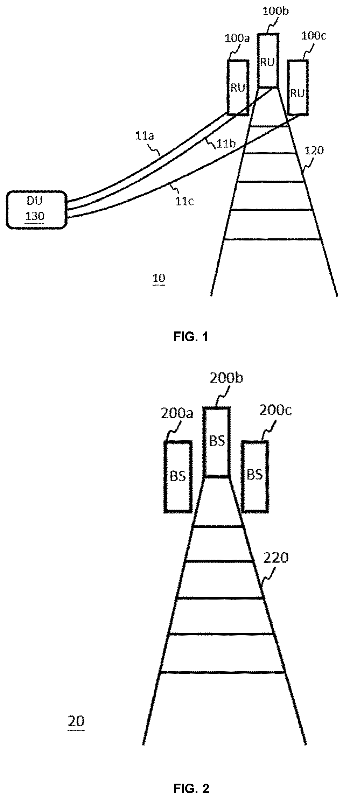

FIG. 1 depicts an illustration of a base station with RUs. RUs 100a to 100c integrate antennas, RF analog circuits, and digital circuits to reduce or avoid cable losses from RRHs. Due to the integration of antennas in the RU, it is more suitable for applications using a larger number of antennas, such as the active antenna architecture of Massive MIMO base stations. Therefore, the fifth-generation (5G) mobile communication may use the base stations with RUs. As shown in FIG. 1, base station 10 includes RUs 100a to 100c, support frame 120, DU 130, and fronthaul interfaces 11a to 11c.

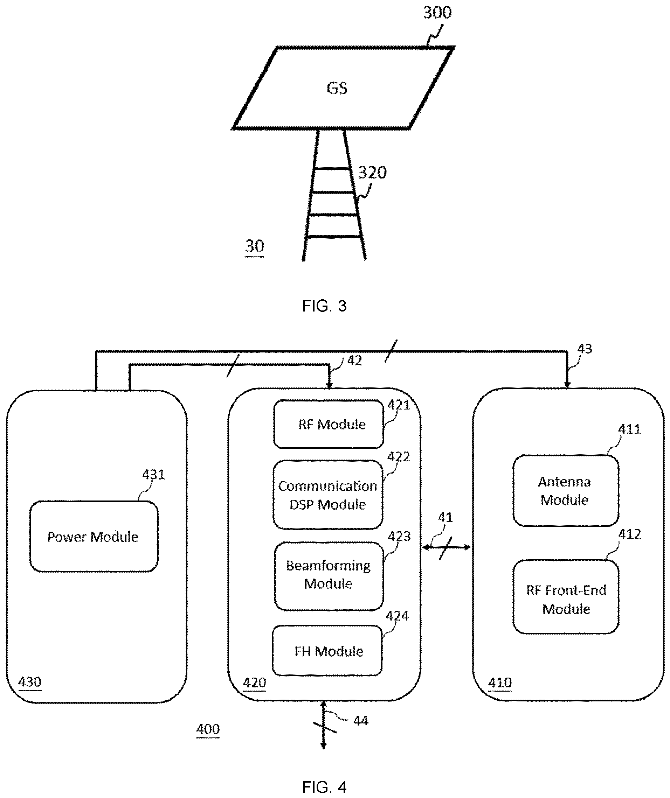

Support frame 120 serves primarily as a support, accommodating RUs 100a to 100c. Each of RUs 100a to 100c comprises antennas, RF analog circuits, and digital circuits. The antennas are utilized for receiving and transmitting wireless radio wave signals. The RF analog circuits comprise a RF front-end module and a RF module, primarily for RF analog signal processing. The digital circuits perform digital signal processing operations related to the low physical layer (Low-PHY), comprising a beamforming module, a communication digital signal processing module, and a fronthaul interface module. The circuit structure of RUs 100a to 100c is the core of the disclosed invention, and is provided in the descriptions of embodiments from FIG. 4 to FIG. 7. RUs 100a to 100c transmit digital data bidirectionally to DU 130 through fronthaul interfaces 11a to 11c. DU 130 executes functions required for the base station, such as the high physical layer (High-PHY), media access control (MAC), and radio link control (RLC).

FIG. 2 depicts an illustration of a base station. In contrast to FIG. 1, base station (BS) circuits 200a to 200c integrate the RU, DU, and CU. The DU comprises baseband digital circuits with functions such as the high-physical layer (High-PHY), media access control (MAC), and radio link control (RLC). The CU, in this disclosure, refers to a system with baseband digital circuits comprising functions of packet data convergence protocol (PDCP) and radio resource control (RRC). For example, the O-CU defined by the O-RAN alliance falls within the scope of the CU as referred to in this disclosure.

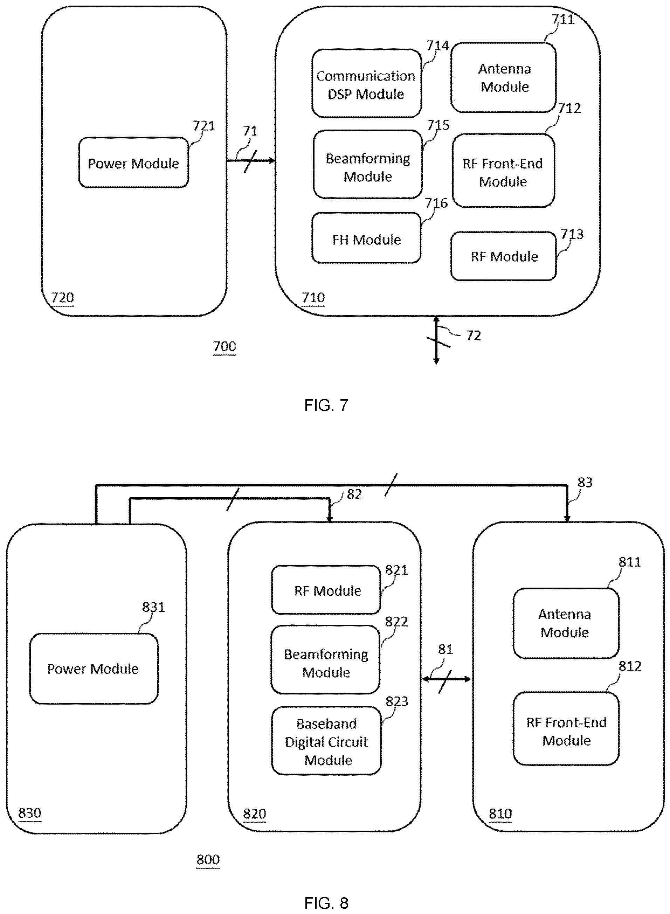

As shown in FIG. 2, base station 20 comprises base station (BS) circuits 200a to 200c and support frame 220. Support frame 220, primarily used as a support, is equipped with base station circuits 200a to 200c on top, each of which comprises antennas, RF analog circuits, and digital circuits. The circuit structure of base station circuits 200a to 200c is the core of the disclosed invention and is provided in the descriptions of embodiments from FIG. 8 to FIG. 10.

FIG. 3 depicts an illustration of a ground station in satellite communications. As shown in FIG. 3, ground station 30 comprises ground station (GS) circuit 300 and support frame 320. Support frame 320 serves primarily as a support, with ground station circuit 300 mounted on top. Ground station circuit 300 comprises antennas, RF analog circuits, and digital circuits. The circuit structure of ground station circuit 300 is the core of the disclosed invention, and is provided in the descriptions of embodiments from FIG. 8 to FIG. 10.

FIG. 4 illustrates a block diagram of a circuit structure for a RU, according to an embodiment disclosed herein. As shown in FIG. 4, circuit structure 400 comprises first PCB 410, second PCB 420, third PCB 430, analog interface 41, analog interface 42, analog interface 43, and fronthaul interface 44.

First PCB 410 comprises antenna module 411 and RF front-end module 412. Antenna module 411 comprises antennas for receiving and transmitting radio wave signals. Antenna module 411 may use a single antenna or multiple antennas, especially having a larger number of antennas, such as 32, 64, 128, or more antennas in Massive MIMO systems. RF front-end module 412 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 421 in second PCB 420 through analog interface 41, and then outputs it to antenna module 411. The low-noise amplifier on the receiving circuit amplifies the signal received by antenna module 411, and then outputs it to RF module 421 in second PCB 420 through analog interface 41.

Second PCB 420 comprises RF module 421, communication digital signal processing (DSP) module 422, beamforming module 423, and fronthaul interface (FH) module 424.

RF module 421 comprises one or more upconvert(s), downconverter(s), filter(s), amplifier(s), and/or attenuator(s). They mainly perform the up/down conversion, filtering, and amplification or attenuation of the analog signals. In the transmitting circuit, the analog signal, generated by the digital to analog converter (DAC) in communication digital signal processing module 422, undergoes filtering through a filter, and the gain of it is adjusted by an amplifier or attenuator. Subsequently, the signal is up-converted to the required carrier frequency of the transmitting signal by an upconverter. Then, the up-converted RF signal is outputted to RF front-end module 412 in first PCB 410 through analog interface 41. In the receiving circuit, the received signal, provided by RF front-end module 412 in first PCB 410, undergoes filtering through a filter, and is down-converted by a downconverter. After adjusting the gain of it through an amplifier or attenuator, the signal is outputted to the analog to digital converter (ADC) in communication digital signal processing module 422.

Communication digital signal processing module 422 comprises two parts: a transmitting part and a receiving part. The transmitting part comprises the following modules: inverse fast Fourier transform (IFFT), cyclic prefix addition (CP Addition), crest factor reduction (CFR), digital pre-distortion (DPD), digital upconverter (DUC), and digital to analog converter (DAC). The frequency-domain signal is first processed by orthogonal frequency division multiplexing (OFDM) modulation through the IFFT and CP Addition, transforming the frequency-domain signal to the time-domain signal. Then, the signal's magnitude is limited within a preset dynamic range by the CFR. The non-linear distortion introduced by the power amplifier in RF front-end module 412 is compensated by the DPD. Finally, the signal's sampling frequency and/or carrier frequency are/is increased through the DUC, and the digital signal is converted to the analog signal by the DAC before being outputted to RF module 421.

Communication digital signal processing module 422, in the receiving part, comprises the following modules: analog to digital converter (ADC), digital downconverter (DDC), cyclic prefix removal (CP Removal), and fast Fourier transform (FFT). First, the analog signal from RF module 421 is converted into the digital signal through the ADC. Then, the DDC processes the signal by reducing the sampling frequency and/or the center frequency. Finally, the signal undergoes the CP Removal and FFT, performing OFDM demodulation to transform the time-domain signal into the frequency-domain signal.

Communication digital signal processing module 422 may also comprises the following modules: physical random access channel (PRACH) filtering processing, automatic gain control (AGC), OFDM phase compensation, antenna calibration, and in-phase and quadrature (I/Q) data compression and decompression. The PRACH processing primarily involves filtering related to the physical random access channel. The AGC is used to achieve automatic gain adjustment. The OFDM phase compensation provides operations to compensate for the phase in OFDM modulation/demodulation. The antenna calibration is used to ensure consistency in gains between the transmitting and receiving antennas and RF circuits. The I/Q data compression and decompression are utilized to reduce the data required for the transmission and reception in fronthaul interface 44.

Beamforming module 423 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Fronthaul interface module 424 serves as a transmitter and receiver for fronthaul interface 44, capable of transmitting data from the RU to the DU and receiving data from the DU to the RU through fronthaul interface 44.

As shown in FIG. 4, the analog signal can be transmitted bidirectionally between first PCB 410 and second PCB 420 through analog interface 41. Analog interface 41 serves as a bidirectional interface for the analog signal, facilitating the communication between RF front-end module 412 and RF module 421.

Third PCB 430 comprises power module 431, which is a power circuit capable of providing power to internal modules of second PCB 420 and first PCB 410 through analog interface 42 and analog interface 43, respectively. Analog interface 42 and analog interface 43 can be any analog interfaces capable of transmitting power, such as power lines or power sockets.

The components or modules of a PCB in this disclosure can be combined in any manner, and such combinations are also within the scope of this disclosure. For example, RF module 421 in second PCB 420 can be an RF integrated circuit (RFIC) further comprising some digital circuits from communication digital signal processing module 422, such as DPD, CFR, AGC, DAC, ADC, DUC, and DDC.

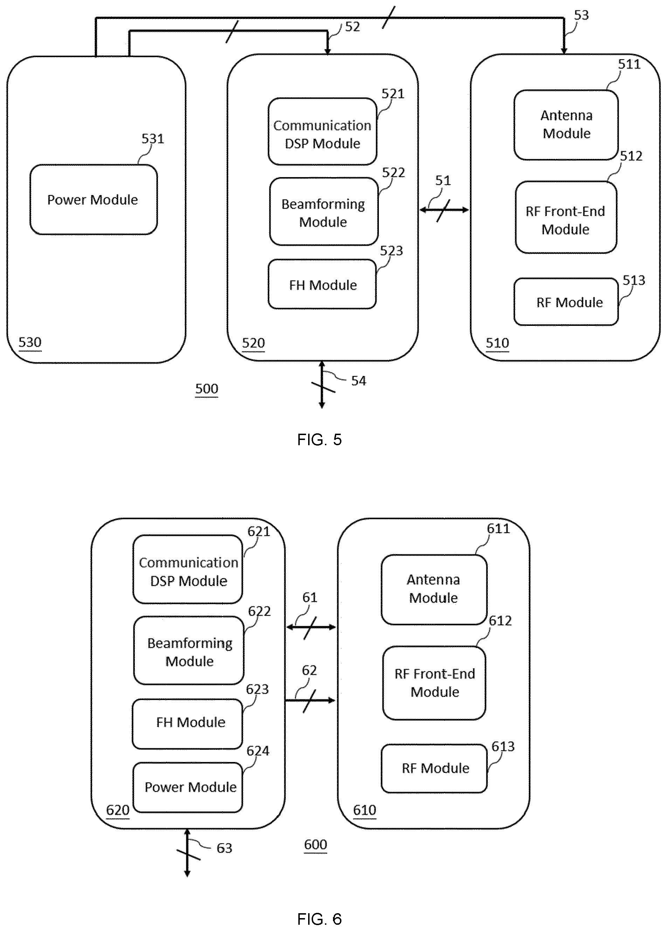

FIG. 5 illustrates a block diagram of a circuit structure for a RU, according to one embodiment disclosed herein. As shown in FIG. 5, circuit structure 500 comprises first PCB 510, second PCB 520, third PCB 530, digital interface 51, analog interface 52, analog interface 53, and fronthaul interface 54.

First PCB 510 comprises antenna module 511, RF front-end module 512, and RF module 513. Antenna module 511 comprises antennas for receiving and transmitting radio wave signals. Antenna module 511 may use a single antenna or multiple antennas, especially having a larger number of antennas, such as 32, 64, 128, or more antennas in Massive MIMO systems. RF front-end module 512 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 513, and then outputs it to antenna module 511. The low-noise amplifier on the receiving circuit amplifies the signal received by antenna module 511, and then outputs it to RF module 513.

In this embodiment, RF module 513 is a RFIC comprising RF analog circuits such as one or more upconverter(s), downconverter(s), filter(s), and amplifier(s) and/or attenuator(s), and some digital circuits such as DPD, CFR, AGC, DAC, ADC, DUC, and DDC.

Second PCB 520 comprises communication digital signal processing (DSP) module 521, beamforming module 522, and fronthaul interface (FH) module 523.

Communication digital signal processing module 521 comprises IFFT and CP Addition in the transmitting part. In the receiving part, communication digital signal processing module 521 comprises FFT and CP Removal. Other digital circuits such as DPD, CFR, AGC, DAC, ADC, DUC, and DDC are integrated into RF module 513. Communication digital signal processing module 521 may also comprise the following modules: PRACH filtering processing, OFDM phase compensation, antenna calibration, and I/Q data compression and decompression. Additionally, communication digital signal processing module 521 bidirectionally transmits digital data to the digital circuits in RF module 513 through digital interface 51.

Beamforming module 522 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Fronthaul interface module 523 serves as a transmitter and receiver for fronthaul interface 54, capable of transmitting data from the RU to the DU and receiving data from the DU to the RU through fronthaul interface 54.

As shown in FIG. 5, the digital signal can be bidirectionally transmitted between first PCB 510 and second PCB 520 through digital interface 51. Digital interface 51 can be implemented by interfaces such as JESD204 (A/B/C), low-voltage differential signaling (LVDS), peripheral component interconnect express (PCIe), or other interfaces.

Third PCB 530 comprises power module 531, which is a power circuit capable of providing power to the internal modules of second PCB 520 and first PCB 510 through analog interface 52 and analog interface 53, respectively. Analog interface 52 and analog interface 53 can be any analog interfaces capable of transmitting power, such as power lines or power sockets.

FIG. 6 illustrates a block diagram of a circuit structure for a RU, according to one embodiment disclosed herein. As shown in FIG. 6, circuit structure 600 comprises first PCB 610, second PCB 620, digital interface 61, analog interface 62, and fronthaul interface 63.

First PCB 610 comprises antenna module 611, RF front-end module 612, and RF module 613. Antenna module 611 comprises antennas for receiving and transmitting radio wave signals. Antenna module 611 may use a single antenna or multiple antennas, especially having a larger number of antennas, such as 32, 64, 128, or more antennas in Massive MIMO systems. RF front-end module 612 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 613, and then outputs it to antenna module 611. The low-noise amplifier on the receiving circuit amplifies the signal received by antenna module 611, and then outputs it to RF module 613.

In this embodiment, RF module 613 is a RFIC comprising RF analog circuits such as one or more upconverter(s), downconverter(s), filter(s), and amplifier(s) and/or attenuator(s), and some digital circuits such as DPD, CFR, AGC, DAC, ADC, DUC, and DDC.

Second PCB 620 comprises communication digital signal processing (DSP) module 621, beamforming module 622, fronthaul interface (FH) module 623, and power module 624.

Communication digital signal processing module 621 comprises IFFT and CP Addition in the transmitting part. In the receiving part, communication digital signal processing module 621 comprises FFT and CP Removal. Other digital circuits such as DPD, CFR, AGC, DAC, ADC, DUC, and DDC are integrated into RF module 613. Communication digital signal processing module 621 may also comprise the following modules: PRACH filtering processing, OFDM phase compensation, antenna calibration, and I/Q data compression and decompression. Additionally, communication digital signal processing module 621 bidirectionally transmits digital data to the digital circuits in RF module 613 through digital interface 61.

Beamforming module 622 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Fronthaul interface module 623 serves as a transmitter and receiver for fronthaul interface 63, capable of transmitting data from the RU to the DU and receiving data from the DU to the RU through fronthaul interface 63.

Power module 624 is a power circuit capable of providing power to the internal modules of first PCB 610 through analog interface 62. Analog interface 62 can be any analog interface capable of transmitting power, such as power lines or power sockets.

As shown in FIG. 6, the digital signal can be bidirectionally transmitted between first PCB 610 and second PCB 620 through digital interface 61. Digital interface 61 can be implemented by interfaces such as JESD204 (A/B/C), LVDS, PCIe, or other interfaces.

FIG. 7 illustrates a block diagram of a circuit structure for a RU, according to one embodiment disclosed herein. As shown in FIG. 7, circuit structure 700 comprises first PCB 710, second PCB 720, analog interface 71, and fronthaul interface 72.

First PCB 710 comprises antenna module 711, RF front-end module 712, RF module 713, communication digital signal processing (DSP) module 714, beamforming module 715, and fronthaul interface (FH) module 716.

Antenna module 711 comprises antennas for receiving and transmitting radio wave signals. Antenna module 711 may use a single antenna or multiple antennas, especially having a larger number of antennas, such as 32, 64, 128, or more antennas in Massive MIMO systems. RF front-end module 712 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 713, and then outputs it to antenna module 711. The low-noise amplifier on the receiving circuit amplifies the signal received by antenna module 711, and then outputs it to RF module 713.

In this embodiment, RF module 713 is a RFIC comprising RF analog circuits such as one or more upconverter(s), downconverter(s), filter(s), and amplifier(s) and/or attenuator(s), and some digital circuits such as DPD, CFR, AGC, DAC, ADC, DUC, and DDC.

Communication digital signal processing module 714 comprises IFFT and CP Addition in the transmitting part. In the receiving part, communication digital signal processing module 714 comprises FFT and CP Removal. Other digital circuits such as DPD, CFR, AGC, DAC, ADC, DUC, and DDC are integrated into RF module 713. Communication digital signal processing module 714 may also comprise the following modules: PRACH filtering processing, OFDM phase compensation, antenna calibration, and I/Q data compression and decompression.

Beamforming module 715 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Fronthaul interface module 716 serves as a transmitter and receiver for fronthaul interface 72, capable of transmitting data from the RU to the DU and receiving data from the DU to the RU through fronthaul interface 72.

Second PCB 720 comprises power module 721, which is a power circuit capable of providing power to the internal modules of first PCB 710 through analog interface 71. Analog interface 71 can be any analog interface capable of transmitting power, such as power lines or power sockets.

FIG. 8 illustrates a block diagram of a circuit structure for a base station and a satellite communication system, according to one embodiment disclosed herein. As shown in FIG. 8, circuit structure 800 comprises first PCB 810, second PCB 820, third PCB 830, analog interface 81, analog interface 82, analog interface 83, and fronthaul interface 84.

First PCB 810 comprises antenna module 811 and RF front-end module 812. Antenna module 811 comprises antennas for receiving and transmitting radio wave signals. Antenna module 811 may use a single antenna or multiple antennas, especially having a larger number of antennas, such as 32, 64, 128, or more antennas in Massive MIMO systems. RF front-end module 812 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 821 in second PCB 820 through analog interface 81, and then outputs it to antenna module 811. The low-noise amplifier on the receiving circuit amplifies the signal received by antenna module 811, and then outputs it to RF module 821 in second PCB 820 through analog interface 81.

Second PCB 820 comprises RF module 821, beamforming module 822, and baseband digital circuit module 823.

RF module 821 comprises one or more upconverter(s), downconverter(s), filter(s), and amplifier(s) and/or attenuator(s). They mainly perform the up/down conversion, filtering, and amplification or attenuation of the analog signals.

Beamforming module 822 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Baseband digital circuit module 823, in this embodiment, refers to digital circuits associated with baseband processing of communication systems. For example, in base station applications, baseband digital circuit module 823 may comprise digital circuits of the communication digital signal processing module in the RU. It may further comprise baseband digital circuits of the DU and/or the CU. In satellite communication applications, the baseband digital circuit module 823 may comprise digital circuits of the baseband processing for satellite communications. For instance, it may comprise digital circuits for operations such as modulation and demodulation.

As shown in FIG. 8, the analog signal can be transmitted bidirectionally between first PCB 810 and second PCB 820 through analog interface 81. Analog interface 81 serves as a bidirectional interface for the analog signal, facilitating the communication between RF front-end module 812 and RF module 821.

Third PCB 830 comprises power module 831, which is a power circuit capable of providing power to internal modules of second PCB 820 and first PCB 810 through analog interface 82 and analog interface 83, respectively. Analog interface 82 and analog interface 83 can be any analog interfaces capable of transmitting power, such as power lines or power sockets.

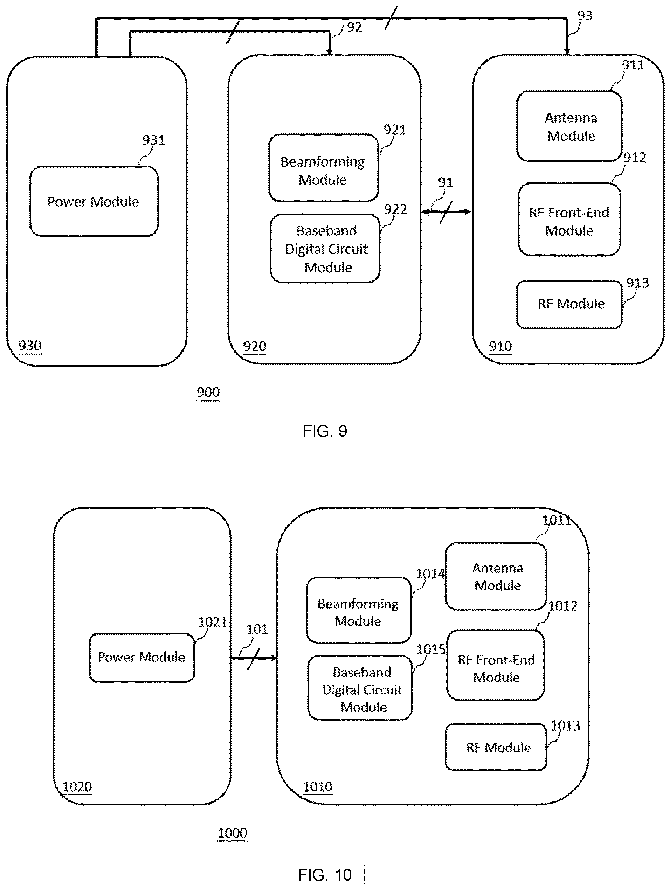

FIG. 9 illustrates a block diagram of a circuit structure for a base station and a satellite communication system, according to one embodiment disclosed herein. As shown in FIG. 9, circuit structure 900 comprises first PCB 910, second PCB 920, third PCB 930, digital interface 91, analog interface 92, and analog interface 93.

First PCB 910 comprises antenna module 911, RF front-end module 912, and RF module 913. Antenna module 911 comprises antennas for receiving and transmitting radio wave signals. Antenna module 911 may use a single antenna or multiple antennas, especially having a larger number of antennas, such as 32, 64, 128, or more antennas in Massive MIMO systems. RF front-end module 912 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 913, and then outputs it to antenna module 911. The low-noise amplifier on the receiving circuit amplifies the signal received by antenna module 911, and then outputs it to RF module 913.

In this embodiment, RF module 913 is a RFIC comprising RF analog circuits such as one or more upconverter(s), downconverter(s), filter(s), and amplifier(s) and/or attenuator(s), and some digital circuits such as DPD, CFR, AGC, DAC, ADC, DUC, and DDC.

Second PCB 920 comprises beamforming module 921 and baseband digital circuit module 922.

Beamforming module 921 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Baseband digital circuit module 922, in this embodiment, refers to digital circuits associated with baseband processing of communication systems. For example, in base station applications, baseband digital circuit module 922 may comprise digital circuits of the communication digital signal processing module in the RU. It may further comprise baseband digital circuits of the DU and/or the CU. In satellite communication applications, the baseband digital circuit module 922 may comprise digital circuits related to the baseband processing for satellite communications. For instance, it may comprise digital circuits for operations such as modulation and demodulation.

As shown in FIG. 9, the digital signal can be bidirectionally transmitted between first PCB 910 and second PCB 920 through digital interface 91. Digital interface 91 can be implemented by interfaces such as JESD204 (A/B/C), LVDS, PCIe, or other interfaces.

Third PCB 930 comprises power module 931, which is a power circuit capable of providing power to internal modules of second PCB 920 and first PCB 910 through analog interface 92 and analog interface 93, respectively. Analog interface 92 and analog interface 93 can be any analog interfaces capable of transmitting power, such as power lines or power sockets.

FIG. 10 illustrates a block diagram of a circuit structure for a base station and a satellite communication system, according to one embodiment disclosed herein. As shown in FIG. 10, circuit structure 1000 comprises first PCB 1010, second PCB 1020, and analog interface 101.

First PCB 1010 comprises antenna module 1011, RF front-end module 1012, RF module 1013, beamforming module 1014, and baseband digital circuit module 1015.

Antenna module 1011 comprises antennas for receiving and transmitting radio wave signals. Antenna module 1011 may use a single antenna or multiple antennas, especially having a larger number of antennas, such as 32, 64, 128, or more antennas in Massive MIMO systems. RF front-end module 1012 comprises one or more transmit/receive switch(es), power amplifier(s), and low-noise amplifier(s). The transmit/receive switch serves as a switch between the transmitting and receiving circuits. The power amplifier on the transmitting circuit amplifies the RF signal generated by RF module 1013, and then outputs it to antenna module 1011. The low-noise amplifier on the receiving circuit amplifies the signal received by antenna module 1011, and then outputs it to RF module 1013.

In this embodiment, RF module 1013 is a RFIC comprising RF analog circuits such as one or more upconverter(s), downconverter(s), filter(s), and amplifier(s) and/or attenuator(s), and some digital circuits such as DPD, CFR, AGC, DAC, ADC, DUC, and DDC.

Beamforming module 1014 primarily performs beamforming operations in both reception and transmission. In the reception, the beamforming operation converts the digital signals from all antennas into the data streams corresponding to all users. In the transmission, the beamforming operation converts the data streams from all users into the digital signals corresponding to all antennas.

Baseband digital circuit module 1015, in this embodiment, refers to digital circuits associated with baseband processing of communication systems. For example, in base station applications, baseband digital circuit module 1015 may comprise digital circuits of the communication digital signal processing module in the RU. It may further comprise baseband digital circuits of the DU and/or the CU. In satellite communication applications, the baseband digital circuit module 1015 may comprise digital circuits related to the baseband processing for satellite communications. For instance, it may comprise digital circuits for operations such as modulation and demodulation.

Second PCB 1020 comprises power module 1021, which is a power circuit capable of providing power to the internal modules of first PCB 1010 through analog interface 101. Analog interface 101 can be any analog interface capable of transmitting power, such as power lines or power sockets.

## Claims

1. A circuit structure for a radio unit (RU), comprising: a plurality of printed circuit boards (PCBs) (400), (500), (600), wherein at least a PCB (410), (510), (610) comprises an antenna module (411), (511), (611), at least a PCB (420), (520), (620) comprises a fronthaul interface module (424), (523), (623), and data and/or signals can be transmitted between the PCBs (410), (420), (430), (510), (520), (530), (610), (620) through any form and any number of unidirectional or bidirectional digital interfaces and/or analog interfaces (41), (42), (43), (51), (52), (53), (61), (62).

2. The circuit structure according to claim 1, wherein the PCB (410) comprising the antenna module (411) further comprises a radio frequency (RF) front-end module (412) and the PCB (420) comprising the fronthaul interface module (424) further comprises a RF module (421), a communication digital signal processing module (422), and a beamforming module (423), wherein the RF front-end module (412) comprises one or more transmit and receive switch(es), power amplifier(s), and low-noise amplifier(s); the RF module (421) comprises one or more upconverter(s), downconverter(s), filter(s), and amplifier(s) and/or attenuator(s); and the communication digital signal processing module (422) comprises at least one or a combination of the following: inverse fast Fourier transform (IFFT), cyclic prefix (CP) addition, crest factor reduction (CFR), digital pre-distortion (DPD), digital upconverter (DUC), digital to analog converter (DAC), analog to digital converter (ADC), digital downconverter (DDC), CP removal, fast Fourier transform (FFT), physical random access channel (PRACH) filtering processing, automatic gain control (AGC), in-phase and quadrature (IQ) data compression and decompression, antenna calibration, and orthogonal frequency division multiplexing (OFDM) phase compensation.

3. The circuit structure according to claim 1, wherein the PCB (510) comprising the antenna module (511) further comprises a RF front-end module (512) and a RF module (513) and the PCB (520) comprising the fronthaul interface module (523) further comprises a communication digital signal processing module (521) and a beamforming module (522), wherein the RF front-end module (512) comprises one or more transmit and receive switch(es), power amplifier(s), and low-noise amplifier(s); the RF module (513) comprises one or more upconverter(s), downconverter(s), filter(s), and amplifier(s) and/or attenuator(s); and the communication digital signal processing module (521) comprises at least one or a combination of the following: IFFT, CP addition, CFR, DPD, DUC, DAC, ADC, DDC, CP removal, FFT, PRACH filtering processing, AGC, IQ data compression and decompression, antenna calibration, and OFDM phase compensation.

4. The circuit structure according to claim 1, further comprising at least a PCB (430), (530), wherein the PCB (430), (530) comprises a power module (431), (531).

5. A circuit structure for a RU, comprising: a plurality of PCBs (400), (500), (600), (700), wherein at least a PCB (410), (510), (610), (710) comprises an antenna module (411), (511), (611), (711), at least a PCB (430), (530), (620), (720) comprises a power module (431), (531), (624), (721), and data and/or signals can be transmitted between the PCBs (410), (420), (430), (510), (520), (530), (610), (620), (710), (720) through any form and any number of unidirectional or bidirectional digital interfaces and/or analog interfaces (41), (42), (43), (51), (52), (53), (61), (62), (71).

6. The circuit structure according to claim 5, wherein the PCB (710) comprising the antenna module (711) further comprises a RF front-end module (712), a RF module (713) a communication digital signal processing module (714), and a beamforming module (715), wherein the RF front-end module (712) comprises one or more transmit and receive switch(es), power amplifier(s), and low-noise amplifier(s); the RF module (713) comprises one or more upconverter(s), downconverter(s), filter(s), and amplifier(s) and/or attenuator(s); and the communication digital signal processing module (714) comprises at least one or a combination of the following: IFFT, CP addition, CFR, DPD, DUC, DAC, ADC, DDC, CP removal, FFT, PRACH filtering processing, AGC, IQ data compression and decompression, antenna calibration, and OFDM phase compensation.

7. A circuit structure for a base station and a satellite communication system, comprising: a plurality of PCBs (800), (900), wherein at least a PCB (810), (910) comprises an antenna module (811), (911), at least a PCB (820), (920) comprises a baseband digital circuit module (823), (922), and data and/or signals can be transmitted between the PCBs (810), (820), (830), (910), (920), (930) through any form and any number of unidirectional or bidirectional digital interfaces and/or analog interfaces (81), (82), (83), (91), (92), (93).

8. The circuit structure according to claim 7, wherein the PCB (810) comprising the antenna module (811) further comprises a RF front-end module (812) and the PCB (820) comprising the baseband digital circuit module (823) further comprises a RF module (821) and a beamforming module (822), wherein the RF front-end module (812) comprises one or more transmit and receive switch(es), power amplifier(s), and low-noise amplifier(s); and the RF module (821) comprises one or more upconverter(s), downconverter(s), filter(s), and amplifier(s) and/or attenuator(s).

9. The circuit structure according to claim 7, wherein the PCB (910) comprising the antenna module (911) further comprises a RF front-end module (912) and a RF module (913) and the PCB (920) comprising the baseband digital circuit module (922) further comprises a beamforming module (921), wherein the RF front-end module (912) comprises one or more transmit and receive switch(es), power amplifier(s), and low-noise amplifier(s); and the RF module (913) comprises one or more upconverter(s), downconverter(s), filter(s), and amplifier(s) and/or attenuator(s).

10. The circuit structure according to claim 7, further comprising at least a PCB (830), (930), wherein the PCB (830), (930) comprises a power module (831), (931).

11. A circuit structure for a base station and a satellite communication system, comprising: a plurality of PCBs (800), (900), (1000), wherein at least a PCB (810), (910), (1010) comprises an antenna module (811), (911), (1011), at least a PCB (830), (930), (1020) comprises a power module (831), (931), (1021), and data and/or signals can be transmitted between the PCBs (810), (820), (830), (910), (920), (930), (1010), (1020) through any form and any number of unidirectional or bidirectional digital interfaces and/or analog interfaces (81), (82), (83), (91), (92), (93), (101).

12. The circuit structure according to claim 11, wherein the PCB (1010) comprising the antenna module (1011) further comprises a RF front-end module (1012), a RF module (1013), a beamforming module (1014), and a baseband digital circuit module (1015), wherein the RF front-end module (1012) comprises one or more transmit and receive switch(es), power amplifier(s), and low-noise amplifier(s); and the RF module (1013) comprises one or more upconverter(s), downconverter(s), filter(s), and amplifier(s) and/or attenuator(s).
